# EUROPEAN PATENT SPECIFICATION

(11) **EP 3 312 213 B1**
(45) Date of publication and mention of the grant of the patent: **01.01.2020**
(21) Application number: 16811304.1
(22) Date of filing: 12.04.2016
(51) Int. Cl.: C08G 59/40, B32B 15/092, B32B 27/20, C08G 61/02, C08G 73/06, C08J 5/24, C08L 63/00, H05K 1/03

(54) **RESIN COMPOSITION, PREPREG, RESIN SHEET, METAL FOIL-CLAD LAMINATE, AND PRINTED WIRING BOARD**
HARZZUSAMMENSETZUNG, PREPREG, HARZFOLIE, MIT EINER METALLFOLIE PLATTIERTES LAMINAT UND LEITERPLATTE
COMPOSITION DE RÉSINE, PRÉIMPRÉGNÉ, FEUILLE DE RÉSINE, STRATIFIÉ REVÊTU D'UNE FEUILLE MÉTALLIQUE, ET CARTE À CÂBLAGE IMPRIMÉ

(30) Priority: 17.06.2015 JP 2015121915
(43) Date of publication of application: 25.04.2018
(73) Proprietor: Mitsubishi Gas Chemical Company, Inc., Tokyo 100-8324 (JP)
(72) Inventor: KOBAYASHI, Takashi, Tokyo 125-8601 (JP); TAKANO, Kentaro, Tokyo 125-8601 (JP)
(74) Representative: Hoffmann Eitle
(86) International application number: PCT/JP2016/061747
(87) International publication number: WO 2016/203829

(56) References cited:
- EP-A1- 1 852 451
- WO-A1-2006/090662
- WO-A1-2014/065422
- WO-A1-2014/203866
- WO-A1-2015/060418
- WO-A1-2015/060418
- JP-A- H11 124 433

## Description

### Technical Field

The present invention relates to a resin composition, a prepreg using the same, a metal foil-clad laminate using the prepreg, a resin sheet, and a printed wiring board.

### Background Art

In recent years, higher integration and miniaturization of semiconductors widely used in electronic equipment, communication instruments, personal computers, and the like have accelerated increasingly. With this, various characteristics required of laminates for semiconductor packages used in printed wiring boards have become increasingly strict. Examples of the required characteristics include characteristics such as low water absorbency, heat resistance after moisture absorption, flame retardancy, a low dielectric constant, a low dielectric loss tangent, a low coefficiency of thermal expansion, heat resistance, and chemical resistance. But, these required characteristics have not always been satisfied so far.

Conventionally, as resins for printed wiring boards having excellent heat resistance and electrical characteristics, cyanate compounds are known, and a resin composition using a bisphenol A-based cyanate compound and another thermosetting resin and the like is widely used for printed wiring board materials and the like. The bisphenol A-based cyanate compound has characteristics excellent in electrical characteristics, mechanical characteristics, chemical resistance, and the like but may be insufficient in low water absorbency, heat resistance after moisture absorption, flame retardancy, and heat resistance, and therefore for the purpose of further improvements in characteristics, various cyanate compounds having different structures are studied.

As a resin having a structure different from that of the bisphenol A-based cyanate compound, a novolac-based cyanate compound is often used (for example, see Patent Literature 1), but there are problems such as the novolac-based cyanate compound being likely to be insufficiently cured, and the water absorption rate of the obtained cured product being high and the heat resistance after moisture absorption decreasing. As a method for improving these problems, prepolymerization of a novolac-based cyanate compound and a bisphenol A-based cyanate compound is proposed (for example, see Patent Literature 2).

In addition, as methods for improving flame retardancy, a halogen-based compound being contained in a resin composition by using a fluorinated cyanate compound or mixing or prepolymerizing a cyanate compound and the halogen-based compound is proposed (for example, see Patent Literatures 3 and 4).

Patent Literature 5 relates to a cyanate ester compound which has good solvent solubility and provides a hardened product having a low coefficiency of thermal expansion, and good flame retardancy and heat resistance.

Patent Literature 6 relates to a method for producing a cyanogen halide, which includes a cyanogen halide-producing step of contacting a halogen molecule with an aqueous solution containing hydrogen cyanide and/or a metal cyanide, so that the hydrogen cyanide and/or the metal cyanide is allowed to react with the halogen molecule in the reaction solution to obtain the cyanogen halide, wherein, in the cyanogen halide-producing step, more than 1 mole of the hydrogen cyanide or the metal cyanide is used based on 1 mole of the halogen molecule, and when an amount of substance of an unreacted hydrogen cyanide or an unreacted metal cyanide is defined as mole (A) and an amount of substance of the generated cyanogen halide is defined as mole (B), the reaction is terminated in a state in which (A) : (A) + (B) is between 0.00009 : 1 and 0.2 : 1.

Patent Literature 7 relates to an epoxy resin characterized by comprising a phenol aralkyl type epoxy resin in which a content (an area % measured by gel permeation chromatography) of a bifunctional compound is 20% or less, and a resin composition obtained therefrom.

### Citation List

### Patent Literature

Patent Literature 1: Japanese Patent Laid-Open No. H11-124433
Patent Literature 2: Japanese Patent Laid-Open No. 2000-191776
Patent Literature 3: Japanese Patent No. 3081996
Patent Literature 4: Japanese Patent Laid-Open No. H06-271669
Patent Literature 5: WO 2015/060418 A1
Patent Literature 6: WO 2014/065422 A1
Patent Literature 7: EP 1 852 451 A1

### Summary of Invention

### Technical Problem

However, in the method described in Patent Literature 2, the curability is improved by prepolymerization, but characteristics improvements in low water absorbency, heat resistance after moisture absorption, and heat resistance are still insufficient, and therefore further improvements in low water absorbency, heat resistance after moisture absorption, and heat resistance are required. In addition, when a halogen-based compound is used as in the methods described in Patent Literatures 3 and 4, a harmful substance such as dioxin may be generated during combustion, and therefore it is required to improve flame retardancy without comprising a halogen-based compound.

The present invention has been made in view of the above problems, and an object of the present invention is to provide a resin composition that can realize a printed wiring board and the like having low water absorbency and moreover also having excellent heat resistance after moisture absorption and an excellent coefficiency of thermal expansion, a prepreg using the same, a metal foil-clad laminate using the prepreg, a resin sheet, and a printed wiring board.

### Solution to Problem

The present inventors have diligently studied the above problems and, as a result, found that a cured product in which excellent water absorbency decreases more and which has heat resistance after moisture absorption is obtained by using a predetermined cyanate compound, arriving at the present invention.

Specifically, the present invention is as follows.
[1] A resin composition comprising:
   a cyanate compound (A) having a structure represented by the following formula (1): 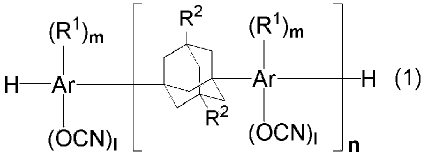 wherein Ar each independently represents an aromatic ring, R¹ each independently represents a hydrogen atom, an alkyl group, or an aryl group, n represents 1.1 to 20 as an average value, 1 each independently represents number of bonded cyanato groups and is an integer of 1 to 3, m each independently represents number of bonded R¹ and represents number obtained by subtracting 1 from number of replaceable groups on Ar, and R² each independently represents a hydrogen atom or an alkyl group having 1 to 4 carbon atoms; and
   an epoxy resin (B).
[2] The resin composition according to [1], wherein the cyanate compound (A) is a cyanate compound obtained by cyanation of a modified adamantane resin.
[3] The resin composition according to [1] or [2], wherein the cyanate compound (A) comprises a cyanate compound having a structure represented by the following formula (2): 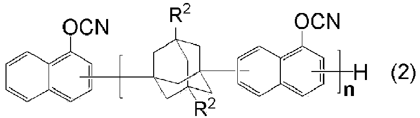 wherein n represents 1.1 to 20 as an average value, and R² each independently represents a hydrogen atom or an alkyl group having 1 to 4 carbon atoms.
[4] The resin composition according to any one of [1] to [3], wherein a content of the cyanate compound (A) is 1 to 90 parts by mass based on 100 parts by mass of resin solids in the resin composition.
[5] The resin composition according to any one of [1] to [4], further comprising a filler (C).
[6] The resin composition according to any one of [1] to [5], further comprising any one or more selected from a group consisting of a cyanate compound other than the cyanate compound (A), a maleimide compound, and a phenolic resin.
[7] The resin composition according to any one of [1] to [6], wherein the epoxy resin (B) comprises any one or more selected from a group consisting of a biphenyl aralkyl-based epoxy resin, a naphthylene ether-based epoxy resin, a polyfunctional phenol-based epoxy resin, and a naphthalene-based epoxy resin.
[8] The resin composition according to any one of [5] to [7], wherein a content of the filler (C) is 50 to 1600 parts by mass based on 100 parts by mass of the resin solids in a resin composition.
[9] A prepreg comprising:
   a base material; and
   the resin composition according to any one of [1] to [8] with which the base material is impregnated or coated.
[10] A metal foil-clad laminate comprising:
   at least one or more of the prepregs according to [9] stacked; and
   metal foil disposed on one surface or both surfaces of the prepreg.
[11] A resin sheet comprising:
   a support; and
   the resin composition according to any one of [1] to [8] with which a surface of the support is coated and which is dried.
[12] A printed wiring board comprising:
   an insulating layer; and
   a conductor layer formed on a surface of the insulating layer, wherein
   the insulating layer comprises the resin composition according to any one of [1] to [8].

### Advantageous Effect of Invention

An object of the present invention is to provide a resin composition that can realize a printed wiring board and the like having low water absorbency and moreover also having excellent heat resistance after moisture absorption and an excellent coefficiency of thermal expansion, a prepreg using the same, a metal foil-clad laminate using the prepreg, a resin sheet, and a printed wiring board.

### Description of Embodiment

A mode for carrying out the present invention (hereinafter referred to as "this embodiment") will be described in detail below, but the present invention is not limited to this, and various modifications can be made without departing from the scope of the claims.

### [Resin Composition]

A resin composition in this embodiment comprises a cyanate compound (A) having a structure represented by the following formula (1); and an epoxy resin (B). 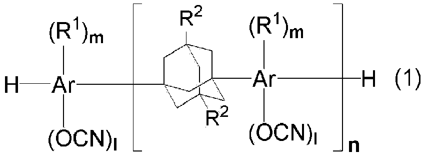 wherein Ar each independently represents an aromatic ring, R¹ each independently represents a hydrogen atom, an alkyl group, or an aryl group, n represents 1.1 to 20 as the average value, 1 each independently represents the number of bonded cyanato groups and is an integer of 1 to 3, m each independently represents the number of bonded R¹ and represents number obtained by subtracting 1 from the number of replaceable groups on Ar, and R² each independently represents a hydrogen atom or an alkyl group having 1 to 4 carbon atoms.

### [Cyanate Compound (A)]

The cyanate compound (A) used in this embodiment has the structure represented by the above formula (1).

In formula (1), Ar each independently represents an aromatic ring. The aromatic ring is not particularly limited. Examples thereof include a phenylene group, a naphthylene group, or a biphenylene group. Among these, a naphthylene group is preferred. By using such Ar, the water absorbency tends to decrease more, and the heat resistance after moisture absorption tends to improve more.

In formula (1), R¹ each independently represents a hydrogen atom, an alkyl group, or an aryl group. The alkyl group may have any of a linear or branched chain structure and a cyclic structure (cycloalkyl group or the like) and is not particularly limited. Examples thereof include a methyl group, an ethyl group, a n-propyl group, an isopropyl group, a cyclopropyl group, a n-butyl group, an isobutyl group, a sec-butyl group, a t-butyl group, a cyclobutyl group, a n-pentyl group, a neopentyl group, a cyclopentyl group, a n-hexyl group, a cyclohexyl group, a n-heptyl group, a n-octyl group, a n-ethylhexyl group, a n-nonyl group, and a n-decyl group. The aryl group is not particularly limited. Examples thereof include a phenyl group and a naphthyl group. Among these, a hydrogen atom is preferred. By using such R¹, the water absorbency and the coefficiency of thermal expansion tend to decrease more, and the heat resistance after moisture absorption tends to improve more.

In formula (1), n represents 1.1 to 20, preferably 1.5 to 10, and more preferably 1.5 to 5 as the average value. When n is in the above range, the water absorbency and the coefficiency of thermal expansion tend to decrease more, and the heat resistance after moisture absorption tends to improve more. The "average value" is a value obtained by dividing the number average molecular weight of the cyanate compound (A) obtained by gel permeation chromatography (GPC) by the molecular weight of the monomer.

In formula (1), 1 each independently represents the number of bonded cyanato groups. 1 is an integer of 1 to 3, preferably an integer of 1 to 2, and more preferably 1. In formula (1), m each independently represents the number of bonded R¹ and represents number obtained by subtracting 1 from the number of replaceable groups on Ar.

In formula (1), R² each independently represents a hydrogen atom or an alkyl group having 1 to 4 carbon atoms. The alkyl group having 1 to 4 carbon atoms is not particularly limited. Examples thereof include a methyl group, an ethyl group, a n-propyl group, an isopropyl group, a n-butyl group, an isobutyl group, a sec-butyl group, and a t-butyl group. The number of carbon atoms of the alkyl group is 1 to 4, preferably 1 to 3, and more preferably 1 to 2.

The weight average molecular weight of the cyanate compound (A) is preferably 500 to 5000, more preferably 600 to 4000, and preferably 700 to 3000. When the weight average molecular weight of the cyanate compound (A) is in the above range, the water absorbency and the coefficiency of thermal expansion tend to decrease more, and the heat resistance after moisture absorption tends to improve more.

As the above cyanate compound (A), a compound in which Ar is a naphthylene group is preferred, and a cyanate compound having a structure represented by the following formula (2) is more preferred. By using such a cyanate compound (A), the water absorbency and the coefficiency of thermal expansion tend to decrease more, and the heat resistance after moisture absorption tends to improve more. 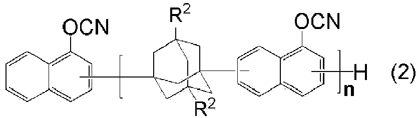 wherein n represents 1.1 to 20 as the average value, and R² each independently represents a hydrogen atom or an alkyl group having 1 to 4 carbon atoms.

In addition, the above cyanate compound (A) is preferably a cyanate compound obtained by cyanation of a modified adamantane resin.

The method for producing the above cyanate compound (A) is not particularly limited. Examples thereof include a method of obtaining or synthesizing a hydroxyl group-containing compound having the desired skeleton, and modifying the hydroxyl group by a known method for cyanation. Specifically, the above cyanate compound (A) can be produced by cyanation of a modified adamantane resin having a hydroxyl group.

The modified adamantane resin having a hydroxyl group is not particularly limited. Examples thereof include a modified adamantane resin represented by the following formula (3): 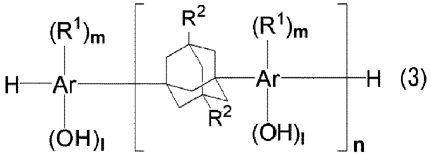 wherein Ar each independently represents an aromatic ring, R¹ each independently represents a hydrogen atom, an alkyl group, or an aryl group, n represents 1.1 to 20 as the average value, and 1 each independently represents the number of bonded hydroxyl groups and is an integer of 1 to 3; and m each independently represents the number of bonded R¹ and represents number obtained by subtracting 1 from the number of replaceable groups on Ar, and R² each independently represents a hydrogen atom or an alkyl group having 1 to 4 carbon atoms.

The method for cyanation of the hydroxyl group is not particularly limited, and known methods can be applied. Specific examples include a method described in Ian Hamerton, "Chemistry and Technology of Cyanate Ester Resins," Blackie Academic & Professional.

The content of the cyanate compound (A) can be appropriately set according to the desired characteristics and is not particularly limited but is preferably 1 to 90 parts by mass, more preferably 10 to 80 parts by mass, further preferably 20 to 70 parts by mass, still further preferably 30 to 60 parts by mass, and particularly preferably 40 to 60 parts by mass based on 100 parts by mass of resin solids in the resin composition. When the content of the cyanate compound (A) is in the above range, the water absorbency and the coefficiency of thermal expansion tend to decrease more, and the heat resistance after moisture absorption tends to improve more. Here, the "resin solids in the resin composition" refers to components in the resin composition excluding a solvent and a filler (C) described later unless otherwise noted, and "100 parts by mass of resin solids" refers to the total of the components in the resin composition excluding the solvent and the filler being 100 parts by mass.

### [Epoxy Resin (B)]

For the epoxy resin (B) used in this embodiment, known ones can be appropriately used as long as they are epoxy resins having two or more epoxy groups in one molecule. The type of the epoxy resin (B) is not particularly limited. Specific examples include bisphenol A-based epoxy resins, bisphenol E-based epoxy resins, bisphenol F-based epoxy resins, bisphenol S-based epoxy resins, phenol novolac-based epoxy resins, bisphenol A novolac-based epoxy resins, glycidyl ester-based epoxy resins, triglycidyl isocyanurate, aralkyl novolac-based epoxy resins, biphenyl aralkyl-based epoxy resins, naphthylene ether-based epoxy resins, cresol novolac-based epoxy resins, xylene novolac-based epoxy resins, dicyclopentadiene novolac-based epoxy resins, biphenyl novolac-based epoxy resins, phenol aralkyl novolac-based epoxy resins, naphthol aralkyl novolac-based epoxy resins, polyfunctional phenol-based epoxy resins, naphthalene-based epoxy resins, anthracene-based epoxy resins, naphthalene skeleton-modified novolac-based epoxy resins, phenol aralkyl-based epoxy resins, naphthol aralkyl-based epoxy resins, dicyclopentadiene-based epoxy resins, biphenyl-based epoxy resins, alicyclic epoxy resins, polyol-based epoxy resins, phosphorus-containing epoxy resins, glycidyl amines, glycidyl esters, compounds obtained by epoxidizing double bonds of butadiene and the like, and compounds obtained by reaction of hydroxyl group-containing silicone resins and epichlorohydrin.

Among these, any one or more selected from the group consisting of biphenyl aralkyl-based epoxy resins, naphthylene ether-based epoxy resins, polyfunctional phenol-based epoxy resins, and naphthalene-based epoxy resins are preferred. By using such an epoxy resin (B), the water absorbency and the coefficiency of thermal expansion tend to decrease more, and the heat resistance after moisture absorption tends to improve more, and in addition the flame retardancy and the heat resistance tend to improve more. One of these epoxy resins can be used alone, or two or more of these epoxy resins can be used in appropriate combination.

The content of the epoxy resin (B) can be appropriately set according to the desired characteristics and is not particularly limited but is preferably 10 to 99 parts by mass, more preferably 20 to 90 parts by mass, further preferably 30 to 80 parts by mass, still further preferably 40 to 70 parts by mass, and particularly preferably 40 to 60 parts by mass based on 100 parts by mass of the resin solids in the resin composition. When the content of the epoxy resin (B) is in the above range, the water absorbency and the coefficiency of thermal expansion tend to decrease more, and the heat resistance after moisture absorption tends to improve more, and in addition the flame retardancy and the heat resistance tend to improve more.

### [Filler (C)]

The resin composition in this embodiment may further contain the filler (C). As the filler (C), known ones can be appropriately used, and the type of the filler (C) is not particularly limited. Inorganic fillers and/or organic fillers generally used in laminate applications can be preferably used.

The inorganic fillers are not particularly limited. Examples thereof include silicas such as natural silica, fused silica, synthetic silica, amorphous silica, AEROSIL, white carbon, and hollow silica; oxides such as titanium white, alumina, zinc oxide, magnesium oxide, boehmite, and zirconium oxide; nitrides such as boron nitride, aggregated boron nitride, silicon nitride, carbon nitride, and aluminum nitride; carbides such as silicon carbide; titanates such as strontium titanate and barium titanate; sulfates or sulfites such as barium sulfate, calcium sulfate, and calcium sulfite; metal hydroxides such as aluminum hydroxide, heat-treated products of aluminum hydroxide (products obtained by heat-treating aluminum hydroxide to decrease some of the water of crystallization), magnesium hydroxide, and calcium hydroxide; molybdenum compounds such as molybdenum oxide and zinc molybdate; carbonates such as calcium carbonate, magnesium carbonate, and hydrotalcite; borates such as zinc borate, barium metaborate, aluminum borate, calcium borate, and sodium borate; stannates such as zinc stannate; and silicates such as gibbsite, boehmite, clay, kaolin, talc, calcined clay, calcined kaolin, calcined talc, mica, E-glass, A-glass, NE-glass, C-glass, L-glass, D-glass, S-glass, M-glass G20, glass short fibers (including fine powders of glass such as E glass, T glass, D glass, S glass, and Q glass), hollow glass, and spherical glass.

In addition, the organic fillers are not particularly limited. Examples thereof include rubber powders such as styrene-based rubber powders, butadiene-based rubber powders, and acrylic rubber powders; core-shell-based rubber powders; silicone resin powders; silicone rubber powders; and silicone composite powders. One of these fillers can be used alone, or two or more of these fillers can be used in appropriate combination.

The content of the filler (C) can be appropriately set according to the desired characteristics and is not particularly limited but is preferably 50 to 1600 parts by mass, more preferably 50 to 1000 parts by mass, further preferably 50 to 500 parts by mass, still further preferably 50 to 250 parts by mass, and particularly preferably 50 to 150 parts by mass based on 100 parts by mass of the resin solids in the resin composition. When the content of the filler (C) is in the above range, the water absorbency and the coefficiency of thermal expansion tend to decrease more, and the heat resistance after moisture absorption tends to improve more.

Here, when the inorganic filler (C) is used, a silane coupling agent and a wetting and dispersing agent are preferably used in combination. As the silane coupling agent, those generally used for surface treatment of inorganic matter can be preferably used, and the type of the silane coupling agent is not particularly limited. Specific examples include aminosilane-based compounds such as γ-aminopropyltriethoxysilane and N-β-(aminoethyl)-γ-aminopropyltrimethoxysilane; epoxysilane-based compounds such as γ-glycidoxypropyltrimethoxysilane and β-(3,4-epoxycyclohexyl)ethyltrimethoxysilane; vinylsilane-based compounds such as γ-methacryloxypropyltrimethoxysilane and vinyl-tri(β-methoxyethoxy)silane; cationic silane-based compounds such as N-β-(N-vinylbenzylaminoethyl)-γ-aminopropyltrimethoxysilane hydrochloride; and phenylsilane-based compounds. One of these silane coupling agents can be used alone, or two or more of these silane coupling agents can be used in appropriate combination. In addition, as the wetting and dispersing agent, those generally used for paints can be preferably used, and the type of the wetting and dispersing agent is not particularly limited. Preferably, copolymer-based wetting and dispersing agents are used. Specific examples thereof include Disperbyk-110, 111, 161, and 180, BYK-W996, BYK-W9010, BYK-W903, and BYK-W940 manufactured by BUK Japan KK. One of these wetting and dispersing agents can be used alone, or two or more of these wetting and dispersing agents can be used in appropriate combination.

### [Curing Accelerator]

In addition, the resin composition in this embodiment may contain a curing accelerator for appropriately adjusting the curing rate, as needed. As this curing accelerator, those generally used as curing accelerators for cyanate compounds, epoxy resins, and the like can be preferably used, and the type of the curing accelerator is not particularly limited. As specific examples thereof, organometallic salts such as zinc octylate, zinc naphthenate, cobalt naphthenate, copper naphthenate, acetylacetone iron, nickel octylate, and manganese octylate, phenol compounds such as phenol, xylenol, cresol, resorcin, catechol, octyl phenol, and nonyl phenol, alcohols such as 1-butanol and 2-ethylhexanol, derivatives such as imidazole derivatives such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole, and adducts of carboxylic acids of these imidazoles or acid anhydrides thereof, amines such as dicyandiamide, benzyldimethylamine, and 4-methyl-N,N-dimethylbenzylamine, phosphorus compounds such as phosphine-based compounds, phosphine oxide-based compounds, phosphonium salt-based compounds, and diphosphine-based compounds, peroxides such as epoxy-imidazole adduct-based compounds, benzoyl peroxide, p-chlorobenzoyl peroxide, di-t-butyl peroxide, diisopropyl peroxycarbonate, and di-2-ethylhexyl peroxycarbonate, or azo compounds such as azobisisobutyronitrile may be used as polymerization catalysts. For these polymerization catalysts, commercial ones may be used. Examples of the commercial products include AJICURE PN-23 (trade name manufactured by Ajinomoto Fine-Techno Co., Inc.), NOVACURE HX-3721 (trade name manufactured by Asahi Kasei Corporation), and Fujicure FX-1000 (trade name manufactured by FUJI KASEI KOGYO CO., LTD.). One of these curing accelerators can be used alone, or two or more of these curing accelerators can be used in appropriate combination.

The amount of the curing accelerator used can be appropriately adjusted considering the degrees of cure of the resins, the viscosity of the resin composition, and the like and is not particularly limited but is usually about 0.005 to 10 parts by mass based on 100 parts by mass of the resin solids in the resin composition.

### [Other Components]

Any one or more selected from the group consisting of a cyanate compound other than the above cyanate compound (A) (hereinafter referred to as "another cyanate compound"), a maleimide compound, and a phenolic resin may be further contained in the resin composition in this embodiment as needed.

### (Another Cyanate Compound)

The another cyanate compound is not particularly limited as long as it is a resin having in the molecule an aromatic moiety substituted by at least one cyanato group. Examples of the another cyanate compound include one represented by the following formula (4): 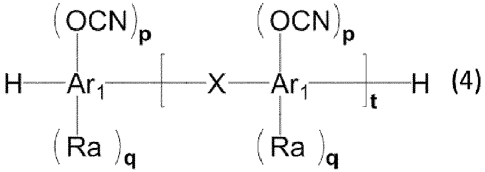 wherein Ar₁ each independently represents a phenylene group, a naphthylene group, or a biphenylene group; Ra each independently represents a hydrogen atom, an alkyl group having 1 to 6 carbon atoms, an aryl group having 6 to 12 carbon atoms, an alkoxy group having 1 to 4 carbon atoms, or a group in which an alkyl group having 1 to 6 carbon atoms and an aryl group having 6 to 12 carbon atoms are mixed; Any position can be selected for the substituents on the aromatic rings; p each independently represents the number of bonded cyanato groups and is an integer of 1 to 3; q each independently represents the number of bonded Ra and is 4 - p when Ar₁ is a phenylene group, 6 - p when Ar₁ is a naphthylene group, and 8 - p when Ar₁ is a biphenylene group; t represents an integer of 0 to 50, and the cyanate compound may be a mixture of compounds having different t; and X each independently represents any of a single bond, a divalent organic group having 1 to 20 carbon atoms (a hydrogen atom may be replaced by a heteroatom) other than an adamantane group, a divalent organic group having 1 to 10 nitrogen atoms (-N-R-N- or the like), a carbonyl group (-CO-), a carboxy group (-C(= O)O-), a carbonyl dioxide group (-OC(= O)O-), a sulfonyl group (-SO₂-), and a divalent sulfur atom or oxygen atom.

The alkyl group for Ra in formula (4) may have any of a linear or branched chain structure and a cyclic structure (cycloalkyl group or the like).

In addition, a hydrogen atom in the alkyl group and the aryl group for Ra in formula
(4) may be replaced by a halogen atom such as fluorine or chlorine, an alkoxy group such as a methoxy group or a phenoxy group, a cyano group, or the like.

Specific examples of the alkyl group for Ra in formula (4) include a methyl group, an ethyl group, a propyl group, an isopropyl group, a n-butyl group, an isobutyl group, a tert-butyl group, a n-pentyl group, a 1-ethylpropyl group, a 2,2-dimethylpropyl group, a cyclopentyl group, a hexyl group, a cyclohexyl group, and a trifluoromethyl group.

Specific examples of the aryl group for Ra in formula (4) include a phenyl group, a xylyl group, a mesityl group, a naphthyl group, a phenoxyphenyl group, an ethylphenyl group, an o-, m-, or p-fluorophenyl group, a dichlorophenyl group, a dicyanophenyl group, a trifluorophenyl group, a methoxyphenyl group, and an o-, m-, or p-tolyl group. Further, examples of the alkoxy group include a methoxy group, an ethoxy group, a propoxy group, an isopropoxy group, a n-butoxy group, an isobutoxy group, and a tert-butoxy group.

Specific examples of the divalent organic group for X in formula (4) include alkylene groups such as a methylene group, an ethylene group, and a trimethylene group, cycloalkylene groups such as a cyclopentylene group, a cyclohexylene group, and a trimethylcyclohexylene group, and divalent organic groups having an aromatic ring such as a biphenylylmethylene group, a dimethylmethylene-phenylene-dimethylmethylene group, a fluorenediyl group, and a phthalidediyl group. A hydrogen atom in the divalent organic group represented by X may be replaced by a halogen atom such as fluorine or chlorine, an alkoxy group such as a methoxy group or a phenoxy group, a cyano group, or the like.

Examples of the divalent organic group having 1 to 10 nitrogen atoms for X in formula (4) include an imino group and a polyimide group.

In addition, examples of X in formula (4) include a group having a structure represented by the following formula (5) or the following formula (6). 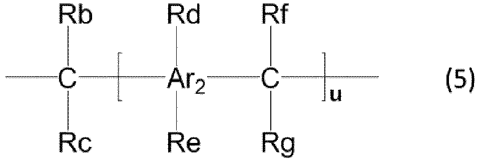 wherein Ar₂ each independently represents a phenylene group, a naphthylene group, or a biphenylene group; Rb, Rc, Rf, and Rg each independently represent a hydrogen atom, an alkyl group having 1 to 6 carbon atoms, an aryl group having 6 to 12 carbon atoms, a trifluoromethyl group, or an aryl group substituted by at least one phenolic hydroxy group; Rd and Re each independently represent a hydrogen atom, an alkyl group having 1 to 6 carbon atoms, an aryl group having 6 to 12 carbon atoms, an alkoxy group having 1 to 4 carbon atoms, or a hydroxy group; and u represents an integer of 0 to 5 and may be the same or different. 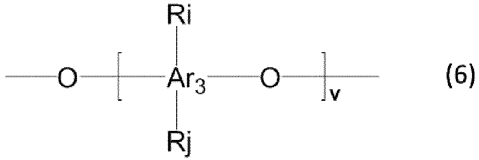 wherein Ar₃ is each independently selected from any one of a phenylene group, a naphthylene group, or a biphenylene group; Ri and Rj each independently represent any of a hydrogen atom, an alkyl group having 1 to 6 carbon atoms, an aryl group having 6 to 12 carbon atoms, a benzyl group, an alkoxy group having 1 to 4 carbon atoms, a hydroxy group, a trifluoromethyl group, or an aryl group substituted by at least one cyanato group; and v represents an integer of 0 to 5, and the cyanate compound may be a mixture of compounds having different v.

Further, examples of X in formula (4) include divalent groups represented by the following formulas: 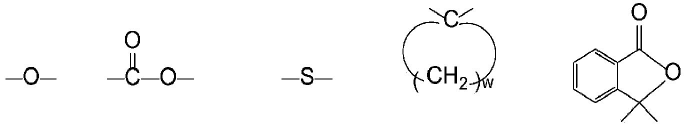 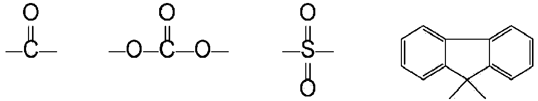 wherein w represents an integer of 4 to 7.

Specific examples of Ar₂ in formula (5) and Ar₃ in formula (6) include a 1,4-phenylene group, a 1,3-phenylene group, a 4,4-biphenylene group, a 2,4-biphenylene group, a 2,2-biphenylene group, a 2,3-biphenylene group, a 3,3-biphenylene group, a 3,4-biphenylene group, a 2,6-naphthylene group, a 1,5-naphthylene group, a 1,6-naphthylene group, a 1,8-naphthylene group, a 1,3-naphthylene group, a 1,4-naphthylene group, and a 2,7-naphthylene group.

The alkyl group and the aryl group for Rb to Rf in formula (5) and Ri and Rj in formula (6) are similar to those described in formula (4).

Specific examples of the resin having in the molecule an aromatic moiety substituted by at least one cyanato group, represented by formula (4) include cyanatobenzene, 1-cyanato-2-, 1-cyanato-3-, or 1-cyanato-4-methylbenzene, 1-cyanato-2-, 1-cyanato-3-, or 1-cyanato-4-methoxybenzene, 1-cyanato-2,3-, 1-cyanato-2,4-, 1-cyanato-2,5-, 1-cyanato-2,6-, 1-cyanato-3,4-, or 1-cyanato-3, 5-dimethylbenzene, cyanatoethylbenzene, cyanatobutylbenzene, cyanatooctylbenzene, cyanatononylbenzene, 2-(4-cyanaphenyl)-2-phenylpropane (a cyanate of 4-α-cumylphenol), 1-cyanato-4-cyclohexylbenzene, 1-cyanato-4-vinylbenzene, 1-cyanato-2- or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene (a cyanate of eugenol), methyl(4-cyanatophenyl)sulfide, 1-cyanato-3-trifluoromethylbenzene, 4-cyanatobiphenyl, 1-cyanato-2- or 1-cyanato-4-acetylbenzene, 4-cyanatobenzaldehyde, methyl 4-cyanatobenzoate ester, phenyl 4-cyanatobenzoate ester, 1-cyanato-4-acetaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-trimethylbenzene, 1,3-dicyanato-2,4,6-trimethylbenzene, 1,3-dicyanato-5-methylbenzene, 1-cyanato- or 2-cyanatonaphthalene, 1-cyanato4-methoxynaphthalene, 2-cyanato-6-methylnaphthalene, 2-cyanato-7-methoxynaphthalene, 2,2-dicyanato-1,1-binaphthyl, 1,3-, 1,4-, 1,5-, 1,6-, 1,7-, 2,3-, 2,6-, or 2,7-dicyanatonaphthalene, 2,2- or 4,4-dicyanatobiphenyl, 4,4-dicyanatooctafluorobiphenyl, 2,4- or 4,4-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl) ether, bis(4-cyanatophenyl) sulfide, bis(4-cyanatophenyl) sulfone, 4-cyanatobenzoic acid-4-cyanatophenyl ester (4-cyanatophenyl-4-cyanatobenzoate), bis-(4-cyanatophenyl) carbonate, 3,3-bis(4-cyanatophenyl)isobenzofuran-1(3H)-one (a cyanate of phenolphthalein), 3,3-bis(4-cyanato-3-methylphenyl)isobenzofuran-1(3H)-one (a cyanate of o-cresolphthalein), 9,9-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methylanilino)-1,3,5-triazine, bis(N-4-cyanato-2-methylphenyl)-4,4-oxydiphthalimide, bis(N-3-cyanato-4-methylphenyl)-4,4-oxydiphthalimide, bis(N-4-cyanatophenyl)-4,4-oxydiphthalimide, bis(N-4-cyanato-2-methylphenyl)-4,4-(hexafluoroisopropylidene)diphthalimide, tris(3,5-dimethyl-4-cyanatobenzyl) isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, phenol novolac-based cyanate compounds, cresol novolac-based cyanate compounds, trisphenol novolac-based cyanate compounds, fluorene novolac-based cyanate compounds, furan ring-containing phenol novolac-based cyanate compounds, phenol aralkyl-based cyanate compounds, cresol aralkyl-based cyanate compounds, naphthol aralkyl-based cyanate compounds, binaphthol aralkyl-based cyanate compounds, naphthol-dihydroxynaphthalene aralkyl-based cyanate compounds, biphenyl aralkyl-based cyanate compounds, phenol-modified xylene formaldehyde-based cyanate compounds, modified naphthalene formaldehyde-based cyanate compounds, phenol-modified dicyclopentadiene-based cyanate compounds, and products obtained by cyanation of phenolic resins by methods similar to the above, such as cyanate compounds of phenolic resins having a polynaphthylene ether structure, and prepolymers thereof but are not particularly limited. One of these cyanate compounds can be used alone, or two or more of these cyanate compounds can be used in appropriate combination.

Examples of the phenol novolac-based cyanate compounds and the cresol novolac-based cyanate compounds include those obtained by cyanation of phenol novolac resins and cresol novolac resins by a known method. Examples of the phenol novolac resins and the cresol novolac resins include those obtained by reacting a phenol, an alkyl-substituted phenol, or a halogen-substituted phenol and a formaldehyde compound such as formalin or paraformaldehyde in an acidic solution by a known method.

Examples of the trisphenol novolac-based cyanate compounds include those obtained by cyanation of trisphenol novolac resins by a known method. Examples of the trisphenol novolac resins include those obtained by reacting hydroxybenzaldehyde and a phenol in the presence of an acidic catalyst by a known method.

Examples of the fluorene novolac-based cyanate compounds include those obtained by cyanation of fluorene novolac resins by a known method. Examples of the fluorene novolac resins include those obtained by reacting a fluorenone compound and a 9,9-bis(hydroxyaryl)fluorene in the presence of an acidic catalyst.

Examples of the furan ring-containing phenol novolac-based cyanate compounds include those obtained by cyanation of furan ring-containing phenol novolac resins by a known method. Examples of the furan ring-containing phenol novolac resins include those obtained by reacting furfural and a phenol in the presence of a basic catalyst by a known method.

Examples of the phenol aralkyl-based cyanate compounds, the cresol aralkyl-based cyanate compounds, the naphthol aralkyl-based cyanate compounds, the biphenyl aralkyl-based cyanate compounds, the naphthol-dihydroxynaphthalene aralkyl-based cyanate compounds, and the biphenyl aralkyl-based cyanate compounds include those obtained by cyanation of phenol aralkyl resins, cresol aralkyl resins, naphthol aralkyl resins, biphenyl aralkyl resins, naphthol-dihydroxynaphthalene aralkyl resins, and biphenyl aralkyl resins by a known method. Examples of the phenol aralkyl resins, the cresol aralkyl resins, the naphthol aralkyl resins, the biphenyl aralkyl resins, the naphthol-dihydroxynaphthalene aralkyl resins, and the biphenyl aralkyl resins include those obtained by reacting a bishalogenomethyl compound as represented by Ar₂-(CH₂Y)₂ and a phenol compound with an acidic catalyst or without a catalyst by a known method, those obtained by reacting a bis(alkoxymethyl) compound as represented by Ar₂-(CH₂OR)₂ or a bis(hydroxymethyl) compound as represented by Ar₂-(CH₂OH)₂ and a phenol compound in the presence of an acidic catalyst by a known method, or those obtained by polycondensing an aromatic aldehyde compound, an aralkyl compound, and a phenol compound by a known method.

Examples of the phenol-modified xylene formaldehyde-based cyanate compounds include those obtained by cyanation of phenol-modified xylene formaldehyde resins by a known method. Examples of the phenol-modified xylene formaldehyde resins include those obtained by reacting a xylene formaldehyde resin and a phenol compound in the presence of an acidic catalyst by a known method.

Examples of the modified naphthalene formaldehyde-based cyanate compounds include those obtained by cyanation of modified naphthalene formaldehyde resins by a known method. Examples of the modified naphthalene formaldehyde resins include those obtained by reacting a naphthalene formaldehyde resin and a hydroxy-substituted aromatic compound in the presence of an acidic catalyst by a known method.

Examples of the phenol-modified dicyclopentadiene-based cyanate compounds, and the cyanate compounds of phenolic resins having a polynaphthylene ether structure include those obtained by cyanation of phenol-modified dicyclopentadiene resins, and phenolic resins having a polynaphthylene ether structure by a known method. Examples of the phenol-modified dicyclopentadiene resins, and the phenolic resins having a polynaphthylene ether structure include those obtained by subjecting a polyvalent hydroxynaphthalene compound having two or more phenolic hydroxy groups in one molecule to dehydration condensation in the presence of a basic catalyst by a known method.

### (Maleimide Compound)

As the maleimide compound, those generally known can be used as long as they are compounds having one or more maleimide groups in one molecule. Examples of the maleimide compound include 4,4-diphenylmethanebismaleimide, bis(3,5-dimethyl-4-maleimidophenyl)methane, bis(3-ethyl-5-methyl-4-maleimidophenyl)methane, bis(3,5-diethyl-4-maleimidophenyl)methane, phenylmethanemaleimide, o-phenylenebismaleimide, m-phenylenebismaleimide, p-phenylenebismaleimide, o-phenylenebiscitraconimide, m-phenylenebiscitraconimide, p-phenylenebiscitraconimide, 2,2-bis(4-(4-maleimidophenoxy)-phenyl)propane, 3,3-dimethyl-5,5-diethyl-4,4-diphenylmethanebismaleimide, 4-methyl-1,3-phenylenebismaleimide, 1,6-bismaleimido-(2,2,4-trimethyl)hexane, 4,4-diphenyl ether bismaleimide, 4,4-diphenyl sulfone bismaleimide, 1,3-bis(3-maleimidophenoxy)benzene, 1,3-bis(4-maleimidophenoxy)benzene, 4,4-diphenylmethanebiscitraconimide, 2,2-bis[4-(4-citraconimidophenoxy)phenyl]propane, bis(3,5-dimethyl-4-citraconimidophenyl)methane, bis(3-ethyl-5-methyl-4-citraconimidophenyl)methane, bis(3,5-diethyl-4-citraconimidophenyl)methane, polyphenylmethanemaleimide, and prepolymers of these maleimide compounds or prepolymers of maleimide compounds and amine compounds but are not particularly limited. One of these maleimide compounds can be used alone, or two or more of these maleimide compounds can be used in appropriate combination.

### (Phenolic Resin)

As the phenolic resin, those generally known can be used as long as they are phenolic resins having two or more hydroxy groups in one molecule. Examples of the phenolic resin include bisphenol A-based phenolic resins, bisphenol E-based phenolic resins, bisphenol F-based phenolic resins, bisphenol S-based phenolic resins, phenol novolac resins, bisphenol A novolac-based phenolic resins, glycidyl ester-based phenolic resins, aralkyl novolac-based phenolic resins, biphenyl aralkyl-based phenolic resins, cresol novolac-based phenolic resins, polyfunctional phenolic resins, naphthol resins, naphthol novolac resins, polyfunctional naphthol resins, anthracene-based phenolic resins, naphthalene skeleton-modified novolac-based phenolic resins, phenol aralkyl-based phenolic resins, naphthol aralkyl-based phenolic resins, dicyclopentadiene-based phenolic resins, biphenyl-based phenolic resins, alicyclic phenolic resins, polyol-based phenolic resins, phosphorus-containing phenolic resins, polymerizable unsaturated hydrocarbon group-containing phenolic resins, and hydroxyl group-containing silicone resins but are not particularly limited. One of these phenolic resins can be used alone, or two or more of these phenolic resins can be used in appropriate combination.

Any one or more of the group consisting of an oxetane resin, a benzoxazine compound, and a compound having a polymerizable unsaturated group may be further contained in the resin composition in this embodiment as needed.

### (Oxetane Resin)

As the oxetane resin, those generally known can be used. Examples of the oxetane resin include oxetane, alkyloxetanes such as 2-methyloxetane, 2,2-dimethyloxetane, 3-methyloxetane, and 3,3-dimethyloxetane, 3-methyl-3-methoxymethyloxetane, 3,3-di(trifluoromethyl)perfluoxetane, 2-chloromethyloxetane, 3,3-bis(chloromethyl)oxetane, biphenyl-based oxetane, OXT-101 (trade name manufactured by Toagosei Co., Ltd.), and OXT-121 (trade name manufactured by Toagosei Co., Ltd.) and are not particularly limited. One of these oxetane resins can be used alone, or two or more of these oxetane resins can be used in appropriate combination.

### (Benzoxazine Compound)

As the benzoxazine compound, those generally known can be used as long as they are compounds having two or more dihydrobenzoxazine rings in one molecule. Examples of the benzoxazine compound include bisphenol A-based benzoxazine BA-BXZ (trade name manufactured by Konishi Chemical Ind. Co., Ltd.) bisphenol F-based benzoxazine BF-BXZ (trade name manufactured by Konishi Chemical Ind. Co., Ltd.), bisphenol S-based benzoxazine BS-BXZ (trade name manufactured by Konishi Chemical Ind. Co., Ltd.), and phenolphthalein-based benzoxazine and are not particularly limited. One of these benzoxazine compounds can be used alone, or two or more of these benzoxazine compounds can be used in appropriate combination.

### (Compound Having Polymerizable Unsaturated Group)

As the compound having a polymerizable unsaturated group, those generally known can be used. Examples of the compound having a polymerizable unsaturated group include ethylene, propylene, styrene, divinylbenzene, and divinylbiphenyl; (meth)acrylates of monohydric or polyhydric alcohols such as methyl (meth)acrylate, 2-hydroxyethyl (meth)acrylate, 2-hydroxypropyl (meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy (meth)acrylates such as bisphenol A-based epoxy (meth)acrylate and bisphenol F-based epoxy (meth)acrylate; benzocyclobutene resins; and (bis)maleimide resins and are not particularly limited. One of these compounds having an unsaturated group can be used alone, or two or more of these compounds having an unsaturated group can be used in appropriate combination.

Further, various polymer compounds such as another thermosetting resin, a thermoplastic resin and an oligomer thereof, and an elastomer, a flame-retardant compound, various additives, and the like can be used in combination in the resin composition in this embodiment as needed. These are not particularly limited as long as they are those generally used. Examples of the flame-retardant compound include bromine compounds such as 4,4'-dibromobiphenyl, phosphates, melamine phosphate, phosphorus-containing epoxy resins, nitrogen compounds such as melamine and benzoguanamine, oxazine ring-containing compounds, and silicone-based compounds. In addition, examples of the various additives include ultraviolet absorbing agents, antioxidants, photopolymerization initiators, fluorescent brightening agents, photosensitizers, dyes, pigments, thickening agents, flow-adjusting agents, lubricants, defoaming agents, dispersing agents, leveling agents, brightening agents, and polymerization inhibitors. One of these can be used alone or two or more of these can be used in appropriate combination as desired.

### (Organic Solvent)

An organic solvent can be used in the resin composition in this embodiment as needed. In this case, the resin composition in this embodiment can be used as a form (solution or varnish) in which at least some, preferably all, of the above-described various resin components are dissolved in or compatible with the organic solvent. As the organic solvent, known ones can be appropriately used as long as they can dissolve or be compatible with at least some, preferably all, of the above-described various resin components. The type of the organic solvent is not particularly limited. Specific examples include polar solvents such as ketones such as acetone, methyl ethyl ketone, and methyl isobutyl ketone; cellosolve-based solvents such as propylene glycol monomethyl ether and propylene glycol monomethyl ether acetate; ester-based solvents such as ethyl lactate, methyl acetate, ethyl acetate, butyl acetate, isoamyl acetate, ethyl lactate, methyl methoxypropionate, and methyl hydroxyisobutyrate; and amides such as dimethylacetamide and dimethylformamide; and nonpolar solvents such as aromatic hydrocarbons such as toluene and xylene. One of these can be used alone, or two or more of these can be used in combination properly.

### [Method for Producing Resin Composition]

The method for producing the resin composition in this embodiment is not particularly limited as long as it is a method of mixing the cyanate compound (A), the epoxy resin (B), and other components as needed. Examples of the method for producing the resin composition in this embodiment include a method of dispersing the filler (C) in the epoxy resin (B) by a homomixer or the like and blending the above cyanate compound (A) therein. Further, an organic solvent is preferably added in order to decrease viscosity to improve handling properties and increase impregnation properties into a glass cloth.

### [Applications]

The resin composition in this embodiment can be used as a prepreg, a metal foil-clad laminate, a resin sheet, an insulating layer of a printed wiring board, and a semiconductor package material. These applications will be described below.

### [Prepreg]

A prepreg in this embodiment comprises a base material; and the above resin composition with which the base material is impregnated or coated. The method for producing the prepreg is not particularly limited as long as it is a method of combining the resin composition in this embodiment and a base material to produce a prepreg. Specifically, the prepreg in this embodiment can be produced by impregnating or coating a base material with the resin composition in this embodiment and then semi-curing the resin composition by a method of drying at 120 to 220°C for about 2 to 15 minutes, or the like. At this time, the amount of the resin composition adhered to the base material, that is, the amount of the resin composition (including the filler (C)) based on the total amount of the prepreg after the semi-curing, is preferably in the range of 20 to 99% by mass.

As the base material used when the prepreg in this embodiment is produced, known ones used for various printed wiring board materials can be used. Examples of the base material include, but are not particularly limited to, woven fabrics of fibers of glass such as E glass, D glass, L glass, S glass, T glass, Q glass, UN glass, NE glass, and spherical glass; inorganic fibers of materials other than glass, such as quartz; organic fibers of polyimides, polyamides, polyesters, and the like; liquid crystal polyesters; and the like. As the shape of the base material, woven fabrics, nonwoven fabrics, rovings, chopped strand mats, surfacing mats, and the like are known, and the shape of the base material may be any. One of these base material can be used alone, or two or more of these base materials can be used in combination properly. In addition, the thickness of the base material is not particularly limited, but is preferably in the range of 0.01 to 0.2 mm in laminate applications. Particularly, woven fabrics subjected to ultra-opening treatment or clogging treatment are preferred from the viewpoint of dimensional stability. Further, glass woven fabrics surface-treated with silane coupling agents for epoxysilane treatment, aminosilane treatment, and the like are preferred from the viewpoint of heat resistance after moisture absorption. In addition, liquid crystal polyester woven fabrics are preferred in terms of electrical characteristics.

### [Metal Foil-Clad Laminate]

On the other hand, a metal foil-clad laminate in this embodiment comprises at least one or more of the above prepregs stacked; and metal foil disposed on one surface or both surfaces of the prepreg. Examples of the method for producing the metal foil-clad laminate include a method of fabricating the metal foil-clad laminate by stacking one or a plurality of the above-described prepregs, disposing foil of a metal such as copper or aluminum on one surface or both surfaces of the stack, and laminate-molding the metal foil and the stack.

The metal foil used here is not particularly limited as long as it is one used for a printed wiring board material. Copper foil such as rolled copper foil and electrolytic copper foil is preferred. In addition, the thickness of the metal foil is not particularly limited but is preferably 2 to 70 µm, more preferably 3 to 35 µm.

As the molding conditions, usual methods for laminates and multilayer boards for printed wiring boards can be applied. For example, the metal foil-clad laminate in this embodiment can be produced by laminate-molding with a temperature of 180 to 350°C, a heating time of 100 to 300 minutes, and a surface pressure of 20 to 100 kg/cm² using a multistage press, a multistage vacuum press, a continuous molding machine, an autoclave molding machine, or the like. In addition, a multilayer board can also be provided by laminate-molding the above prepreg and a separately fabricated wiring board for an inner layer in combination. As the method for producing a multilayer board, for example, a multilayer board can be fabricated by disposing 35 µm copper foil on both surfaces of one of the above-described prepreg, laminating and forming the copper foil and the prepreg under the above conditions, then forming inner layer circuits, subjecting these circuits to blackening treatment to form an inner layer circuit board, then alternately disposing these inner layer circuit boards and the above prepregs one by one, further disposing copper foil on the outermost layers, and laminate-molding the copper foil, the inner layer circuit boards, and the prepregs under the above conditions preferably under vacuum. The metal foil-clad laminate in this embodiment can be preferably used as a printed wiring board.

### [Printed Wiring Board]

A printed wiring board in this embodiment comprises an insulating layer; and a conductor layer formed on a surface of the insulating layer, and the above insulating layer comprises the above resin composition. The printed wiring board can be produced according to an ordinary method, and the method for producing the printed wiring board is not particularly limited. One example of a method for producing a printed wiring board will be shown below. First, a metal foil-clad laminate such as the above-described copper-clad laminate is provided. Next, the surfaces of the metal foil-clad laminate are subjected to etching treatment to form inner layer circuits to fabricate an inner layer board. The inner layer circuit surfaces of this inner layer board are subjected to surface treatment for increasing adhesive strength, as needed. Then, the required number of the above-described prepregs are stacked on the inner layer circuit surfaces, metal foil for outer layer circuits is further laminated on the outside of the stack, and heat and pressure are applied for integral molding. In this manner, a multilayer laminate in which insulating layers comprising a base material and a cured product of a thermosetting resin composition are formed between inner layer circuits and metal foil for outer layer circuits is produced. Then, this multilayer laminate is subjected to perforation for through holes and via holes, and then plating metal films that allow conduction between the inner layer circuits and the metal foil for outer layer circuits are formed on the wall surfaces of these holes. Further, the metal foil for outer layer circuits is subjected to etching treatment to form outer layer circuits. Thus, a printed wiring board is produced.

The printed wiring board obtained in the above production example has a configuration in which it has insulating layers and conductor layers formed on surfaces of these insulating layers, and the insulating layers comprise the resin composition in this embodiment described above. In other words, the prepreg in this embodiment described above (the base material and the resin composition in this embodiment with which the base material is impregnated or coated) and the resin composition layer of the metal foil-clad laminate in this embodiment described above (the layer comprising the resin composition in this embodiment) are composed of an insulating layer comprising the resin composition in this embodiment.

### [Resin Sheet]

A resin sheet in this embodiment comprises a support; and the above resin composition with which a surface of the support is coated and which is dried. The resin sheet can be obtained by coating a support with a solution of the above resin composition in this embodiment dissolved in a solvent and drying the solution. The resin sheet can be used as a buildup film or a dry film solder resist.

Examples of the support used here include organic film base materials such as polyethylene films, polypropylene films, polycarbonate films, polyethylene terephthalate films, ethylene-tetrafluoroethylene copolymer films, and release films obtained by coating surfaces of these films with release agents, and polyimide films; conductor foil such as copper foil and aluminum foil; and plate-shaped supports such as glass plates, SUS plates, and FRP but are not particularly limited.

Examples of the method for coating with the resin composition include a method of coating a support with a solution of the resin composition in this embodiment dissolved in a solvent by a bar coater, a die coater, a doctor blade, a baker applicator, or the like. In addition, a single-layer sheet (resin sheet) can also be provided by peeling or etching the support from the laminated sheet after drying. A single-layer sheet (resin sheet) can also be obtained without using a support by supplying a solution of the above resin composition in this embodiment dissolved in a solvent into a mold having a sheet-shaped cavity, and drying the solution, or the like for molding into a sheet shape.

In fabrication of the single-layer or laminated sheet in this embodiment, the drying conditions when the solvent is removed are not particularly limited but are preferably a temperature of 20°C to 200°C for 1 to 90 minutes because at low temperature, the solvent is likely to remain in the resin composition, and at high temperature, curing of the resin composition proceeds. In addition, the thickness of the resin layer of the single-layer or laminated sheet in this embodiment can be adjusted by the concentration and coating thickness of the solution of the resin composition in this embodiment and is not particularly limited but is preferably 0.1 to 500 µm because generally, when the coating thickness increases, the solvent is likely to remain during drying. In addition, the resin composition can also be used in an uncured state in which the solvent is only dried, or in a semi-cured (B-staged) state as needed.

### Examples

The present invention will be described in more detail below by showing Synthesis Examples, an Example, and a Comparative Example, but the present invention is not limited to these.

### (Synthesis Example 1) Synthesis of Cyanate Compound of Modified Adamantane Resin (Hereinafter Abbreviated as "mAMT-CN")

mAMT-CN represented by the following formula (7) was synthesized as described later. 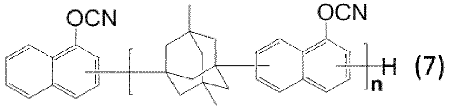 wherein n is 2.0 as the average value.

### <Synthesis of Modified Adamantane Resin 1 (Hereinafter Abbreviated as "mAMT-OH")>

First, mAMT-OH represented by the following formula (8) was synthesized. 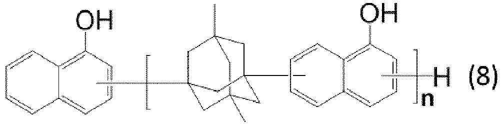 wherein n is 2.0 as the average value.

368.0 g of 1,3-dimethyladamantane-5,7-diol (1.88 mol, manufactured by MITSUBISHI GAS CHEMICAL COMPANY, INC.) and 540.0 g of 1-naphthol (3.75 mol, manufactured by Wako Pure Chemical Industries, Ltd.) were charged into a fournecked flask having an internal volume of 2.0 L equipped with a Liebig condenser tube, a thermometer, and a stirring blade under a nitrogen gas flow and heated and melted at 160°C. Then, while the mixed liquid was stirred, 180 mg of methanesulfonic acid (manufactured by Wako Pure Chemical Industries, Ltd.) was added to start a reaction. While the reaction liquid was stirred, the temperature of the reaction liquid was increased to 220°C over 90 minutes, and then the reaction liquid was further maintained in a state of 220°C for 90 minutes. At this time, the methanesulfonic acid was added to the reaction liquid over 1 hour. Then, the reaction liquid was diluted with 1600 g of a mixed solvent (meta-xylene (manufactured by MITSUBISHI GAS CHEMICAL COMPANY, INC.)/methyl isobutyl ketone (manufactured by KANTO CHEMICAL CO., INC.) = 1/1 (weight ratio)) and then subjected to water washing with a 0.5% by mass sodium hydroxide aqueous solution and with neutralization water, and further the solvent was removed under reduced pressure to obtain 694.0 g of mAMT-OH. The OH group equivalent of the obtained mAMT-OH was 257 g/eq.

### <Synthesis of mAMT-CN>

Next, 515 g of the mAMT-OH obtained by the above method (OH group equivalent 257 g/eq.) (2.00 mol in terms of OH groups) and 304.2 g (3.01 mol) (1.5 mol based on 1 mol of hydroxy groups) of triethylamine were dissolved in 3090 g of dichloromethane, and this solution was a solution 1.

209.4 g (3.41 mol) (1.7 mol based on 1 mol of hydroxy groups) of cyanogen chloride, 488.6 g of dichloromethane, 324.7 g (3.21 mol) (1.6 mol based on 1 mol of hydroxy groups) of 36% hydrochloric acid, and 2013 g of water were mixed to provide a solution 2. While the solution 2 was kept at a liquid temperature of -2 to - 0.5°C under stirring, the solution 1 was poured into the solution 2 over 55 minutes. After completion of pouring of the solution 1, the mixture was stirred at the same temperature for 30 minutes, and then a solution of 141.9 g (1.40 mol) (0.7 mol based on 1 mol of hydroxy groups) of triethylamine dissolved in 141.9 g of dichloromethane (solution 3) was poured into the solution 2 over 20 minutes. After completion of pouring of the solution 3, the mixture was stirred at the same temperature for 30 minutes to complete the reaction.

Then, the reaction liquid was allowed to stand to separate the organic phase and the aqueous phase. The obtained organic phase was washed with 2 L of 0.1 N hydrochloric acid and then washed six times with 2000 g of water. The electrical conductivity of the wastewater from the sixth water washing was 20 µS/cm, and it was confirmed that removable ionic compounds were sufficiently removed by the washing with water.

The organic phase after the water washing was concentrated under reduced pressure and finally concentrated to dryness at 90°C for 1 hour to obtain 559 g of the target cyanate compound mAMT-CN (black-purple viscous material). The weight average molecular weight Mw of the obtained cyanate compound mAMT-CN was 830. In addition, the IR spectrum of mAMT-CN showed absorption at 2257 cm⁻¹ (cyanate groups) and showed no absorption of hydroxy groups. It was possible to dissolve 50% by mass or more of mAMT-CN in methyl ethyl ethyl ketone at 25°C.

### (Measurement of OH Group Equivalent (g/eq.) of Hydroxy-Substituted Aromatic Compound)

The OH group equivalent (g/eq.) was obtained by a pyridine-acetyl chloride method in accordance with JIS-K0070.

### (Measurement of Weight Average Molecular Weight Mw of Cyanate Compound (A))

10 µL of a solution of 1 g of a cyanate compound dissolved in 100 g of tetrahydrofuran (solvent) was injected into high performance liquid chromatography (high performance liquid chromatography LachromElite manufactured by Hitachi High-Technologies Corporation) and analyzed. The columns are two of TSKgel GMHHR-M (length 30 cm × inner diameter 7.8 mm) manufactured by Tosoh Corporation, the mobile phase is tetrahydrofuran, the flow velocity is 1 mL/min., and the detector is RI. The weight average molecular weight Mw was obtained by a GPC method using polystyrene as a standard substance. The average value n was calculated based on the weight average molecular weight.

### (Synthesis Example 2) Synthesis of 1,3-Bis(4-cyanatophenyl)adamantane (Hereinafter Abbreviated as "uAMTCN")

uAMTCN represented by the following formula (9) was synthesized as described later.

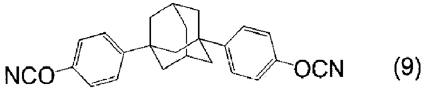

### <Synthesis of 1,3-Bis(4-hydroxyphenyl)adamantane (Hereinafter Abbreviated as "uAMTOH")>

First, uAMTOH represented by the following formula (10) was synthesized.

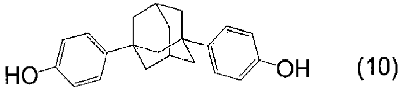

Specifically, under a nitrogen gas flow, 70.6 g (0.42 mol) of adamantane-1,3-diol and 312.5 g (3.36 mol) of phenol were charged, and heated and melted at 80°C, and then while the mixture was stirred, 40.62 g (0.42 mol) of methanesulfonic acid was added, and the mixture was reacted at about 90°C for 7 hours. Then, 600 mL of water was added, and the mixture was stirred for 1 hour as it was. The precipitate was filtered off, and then washing of the obtained crystals with 600 mL of hot water was repeated three times. The crystals after the washing were dissolved in a mixed solvent of 1200 mL of ethyl acetate and 400 mL of toluene, washed once with 300 mL of a 0.5% by mass NaOH aqueous solution, and then repeatedly washed with 300 mL of water until the pH of the aqueous phase became neutral. The organic phase after the water washing was concentrated to dryness under reduced pressure to obtain a solid. The obtained solid was dissolved in 600 mL of ethyl acetate at 65°C. 1200 mL of heptane at room temperature was added thereto, and the mixture was stirred for 30 minutes to obtain a precipitate. The precipitate was filtered off, then washed five times with 300 mL of heptane, and finally dried at 80°C for 8 hours to obtain 92 g of uAMTOH (white solid). The structure of uAMTOH was identified by NMR.
¹H-NMR: (500 MHz, ACETONE-D6)
δ (ppm) = 1.69 (s, 2H), 1.82 (s, 8H), 1.86 (s, 2H), 2.17 (s, 2H), 6.71 (d, J = 7.4 Hz, 4H), 7.16 (d, J = 7.4 Hz, 4H)

### <Synthesis of uAMTCN>

Next, 35 g of the uAMTOH obtained by the above method (OH group equivalent: 160.2 g/eq., 0.218 mol in terms of hydroxy groups) and 22.5 g (0.218 mol, 1.0 mol based on 1 mol of the hydroxy groups of uAMTOH) of triethylamine were dissolved in 140 g of tetrahydrofuran, and this solution was a solution 5.

While a mixture of 27.0 g (0.44 mol, 2.0 mol based on 1 mol of the hydroxy groups of uAMTOH) of cyanogen chloride, 63.0 g of dichloromethane, and 280 g of tetrahydrofuran was kept at a liquid temperature of -7 to -5°C under stirring, the solution 5 was poured thereinto over 1 hour. After completion of pouring of the solution 5, the mixture was stirred at the same temperature for 30 minutes, and then a solution of 13.5 g (0.13 mol, 0.6 mol based on 1 mol of the hydroxy groups of uAMTOH) of triethylamine dissolved in 13.5 g of tetrahydrofuran (solution 6) was poured thereinto over 15 minutes. After completion of pouring of the solution 6, the mixture was stirred at the same temperature for 30 minutes to complete the reaction.

Then, the hydrochloride of triethylamine was filtered off, and the obtained filtrate was washed with 180 g of 0.1 N hydrochloric acid and then washed seven times with 180 g of water. The electrical conductivity of the wastewater from the seventh water washing was 20 µS/cm, and it was confirmed that removable ionic compounds were sufficiently removed by the washing with water.

The organic phase after the water washing was concentrated under reduced pressure and concentrated to dryness at 90°C for 1 hour to obtain 39 g of crystals of a yellow-white solid. The obtained crystals were dissolved in 98 g of methyl ethyl ketone (MEK) and 21 g of n-hexane at 90°C and then recrystallized. The obtained crystals were washed with 200 mL of n-hexane and then dried under reduced pressure to obtain 20 g of the target cyanate compound uAMTCN (pale yellow crystals). The structure of the obtained cyanate compound uAMTCN was identified by NMR. The ¹H-NMR spectrum is shown in Figure 8.
¹H-NMR: (500 MHz, CDCl3)

δ (ppm) = 1.79 (m, 2H), 1.94 (d, J = 2.8 Hz, 8H), 1.97 (s, 2H), 2.36 (m, 2H), 7.25 (ddd, J = 2.0, 3.2, 8.9 Hz), 7.45 (ddd, J = 2.0, 3.2, 8.9 Hz)
The IR spectrum of uAMTCN showed absorption at 2238 cm⁻¹ and 2266 cm⁻¹ (cyanate groups) and showed no absorption of hydroxy groups.

It was possible to dissolve 30% by mass or more of uAMTCN in methyl ethyl ketone (MEK) at 25°C.

### (Example 1)

50 parts by mass of the mAMT-CN obtained by Synthesis Example 1, 50 parts by mass of a biphenyl aralkyl-based epoxy resin (NC-3000-FH, manufactured by Nippon Kayaku Co., Ltd.), and 100 parts by mass of fused silica (SC2050MB, manufactured by Admatechs Company Limited) were mixed to obtain a varnish. This varnish was diluted with methyl ethyl ketone, and an E-glass woven fabric having a thickness of 0.1 mm was impregnated and coated with the diluted varnish and heated and dried at 150°C for 5 minutes to obtain a prepreg having a resin content of 50% by mass.

Four and eight of the obtained prepregs were stacked, and 12 µm thick electrolytic copper foil (3EC-M3-VLP, manufactured by MITSUI MINING & SMELTING CO., LTD.) was disposed on the tops and the bottoms. The stacks were laminate-molded at a pressure of 30 kgf/cm² and a temperature of 220°C for 120 minutes to obtain metal foil-clad laminates having insulating layer thicknesses of 0.4 mm and 0.8 mm. Evaluation of a water absorption rate and heat resistance after moisture absorption was performed using the obtained metal foil-clad laminates. The results are shown in Table 1.

### (Measurement Methods and Evaluation Methods)

1) Water absorption rate: The water absorption rate after treatment at 121°C and 2 atmospheres by a pressure cooker tester (manufactured by HIRAYAMA MANUFACTURING CORPORATION, model PC-3) for 5 hours was measured in accordance with JIS C648 using a 30 mm × 30 mm sample of the obtained metal foil-clad laminate by stacking eight prepregs.
2) Heat resistance after moisture absorption: A test piece obtained by removing all the copper foil of a 50 mm × 50 mm sample of the obtained metal foil-clad laminate by stacking eight prepregs except half of the copper foil on one surface by etching was treated at 121°C and 2 atmospheres by a pressure cooker tester (manufactured by HIRAYAMA MANUFACTURING CORPORATION, model PC-3) for 5 hours and then immersed in solder at 260°C for 60 seconds. Then, appearance change was visually observed. (the number of occurrences of blistering/the number of tests)
3) Coefficiency of thermal expansion: For the obtained metal foil-clad laminate having an insulating layer thickness of 0.8 mm, the coefficiency of thermal expansion in the thickness direction of a specimen for the insulating layer of the laminate was measured by the TMA method (Thermo-mechanical analysis) defined in JIS C 6481, and the value was obtained. Specifically, the copper foil on both surfaces of the metal foil-clad laminate obtained above was removed by etching, and then the temperature was increased by 10°C per minute from 40°C to 340°C by a thermo-mechanical analysis apparatus (manufactured by TA Instruments), and the linear coefficiency of thermal expansion at 60°C to 120°C (ppm/°C) was measured.

### (Comparative Example 1)

Metal foil-clad laminates having thicknesses of 0.4 mm and 0.8 mm were obtained as in Example 1 except that 50 parts by mass of a bisphenol A-based cyanate compound (CA210, manufactured by MITSUBISHI GAS CHEMICAL COMPANY, INC.) was used instead of using 50 parts by mass of mAMT-CN in Example 1. The evaluation results of the obtained metal foil-clad laminates are shown in Table 1.

### (Comparative Example 2)

Metal foil-clad laminates having thicknesses of 0.4 mm and 0.8 mm were obtained as in Example 1 except that 50 parts by mass of a phenol novolac-based cyanate compound (Primaset PT-30, manufactured by Lonza Japan Ltd.) was used instead of using 50 parts by mass of mAMT-CN in Example 1. The evaluation results of the obtained metal foil-clad laminates are shown in Table 1.

### (Comparative Example 3)

Metal foil-clad laminates having thicknesses of 0.4 mm and 0.8 mm were obtained as in Example 1 except that 50 parts by mass of the uAMTCN obtained in Synthesis Example 2 was used instead of using 50 parts by mass of mAMT-CN in Example 1. The evaluation results of the obtained metal foil-clad laminates are shown in Table 1.

**[Table 1]**

| | | Example 1 | Comparative Example 1 | Comparative Example 2 | Comparative Example 3 |
|---|---|---|---|---|---|
| Water absorption rate (%) | After treatment for 5 hours | 0.27 | 0.38 | 0.52 | 0.39 |
| Heat resistance after moisture absorption | After treatment for 5 hours | 0/4 | 3/4 | 1/4 | 0/4 |
| Coefficiency of thermal expansion | | 10.2 | 10.5 | 12.3 | 12 |

As is clear from Table 1, it was confirmed that by using the resin composition of the present invention, a prepreg, a printed wiring board, and the like not only having low water absorbency but also having excellent heat resistance after moisture absorption and an excellent coefficiency of thermal expansion were realized.

This application is based on Japanese Patent Application No. 2015-121915 filed with the Japan Patent Office on June 17, 2015, the contents of which are incorporated herein by reference.

### Industrial Applicability

As described above, the resin composition of the present invention can be widely and effectively used in various applications such as electrical and electronic materials, machine tool materials, and aviation materials, for example, as electrical insulating materials, semiconductor plastic packages, sealing materials, adhesives, lamination materials, resists, and buildup laminate materials, and, particularly, can be especially effectively used as printed wiring board materials adapted to higher integration and higher density for information terminal equipment, communication equipment, and the like in recent years. In addition, the laminate, metal foil-clad laminate, and the like of the present invention have performance also excellent in heat resistance after moisture absorption in addition to water absorbency, and therefore their industrial practicality is extremely high.

## Claims

1. A resin composition comprising:
a cyanate compound (A) having a structure represented by the following formula (1): 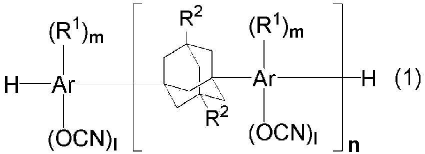 wherein Ar each independently represents an aromatic ring, R¹ each independently represents a hydrogen atom, an alkyl group, or an aryl group, n represents 1.1 to 20 as an average value, 1 each independently represents number of bonded cyanato groups and is an integer of 1 to 3, m each independently represents number of bonded R¹ and represents number obtained by subtracting 1 from number of replaceable groups on Ar, and R² each independently represents a hydrogen atom or an alkyl group having 1 to 4 carbon atoms; and
an epoxy resin (B).

2. The resin composition according to claim 1, wherein the cyanate compound (A) is a cyanate compound obtained by cyanation of a modified adamantane resin.

3. The resin composition according to claim 1 or 2, wherein the cyanate compound (A) comprises a cyanate compound having a structure represented by the following formula (2): 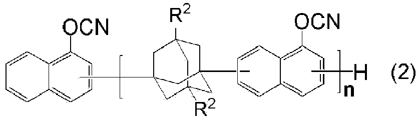 wherein n represents 1.1 to 20 as an average value, and R² each independently represents a hydrogen atom or an alkyl group having 1 to 4 carbon atoms.

4. The resin composition according to any one of claims 1 to 3, wherein a content of the cyanate compound (A) is 1 to 90 parts by mass based on 100 parts by mass of resin solids in the resin composition.

5. The resin composition according to any one of claims 1 to 4, further comprising a filler (C).

6. The resin composition according to any one of claims 1 to 5, further comprising any one or more selected from a group consisting of a cyanate compound other than the cyanate compound (A), a maleimide compound, and a phenolic resin.

7. The resin composition according to any one of claims 1 to 6, wherein the epoxy resin (B) comprises any one or more selected from a group consisting of a biphenyl aralkyl-based epoxy resin, a naphthylene ether-based epoxy resin, a polyfunctional phenol-based epoxy resin, and a naphthalene-based epoxy resin.

8. The resin composition according to any one of claim 5 to 7, wherein a content of the filler (C) is 50 to 1600 parts by mass based on 100 parts by mass of the resin solids in a resin composition.

9. A prepreg comprising:
a base material; and
the resin composition according to any one of claims 1 to 8 with which the base material is impregnated or coated.

10. A metal foil-clad laminate comprising:
at least one or more of the prepregs according to claim 9 stacked; and
metal foil disposed on one surface or both surfaces of the prepreg.

11. A resin sheet comprising:
a support; and
the resin composition according to any one of claims 1 to 8 with which a surface of the support is coated and which is dried.

12. A printed wiring board comprising:
an insulating layer; and
a conductor layer formed on a surface of the insulating layer, wherein
the insulating layer comprises the resin composition according to any one of claims 1 to 8.

## Patentansprüche

1. Harzzusammensetzung, umfassend:
eine Cyanatverbindung (A), die eine Struktur der folgenden Formel (1) aufweist: 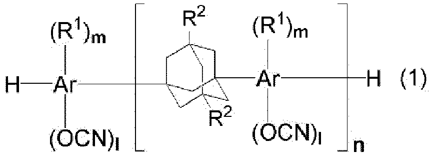 worin Ar jeweils unabhängig voneinander einen aromatischen Ring darstellt, R¹ jeweils unabhängig voneinander ein Wasserstoffatom, eine Alkylgruppe oder eine Arylgruppe darstellt, n 1,1 bis 20 als Mittelwert darstellt, l jeweils unabhängig voneinander die Anzahl der gebundenen Cyanatgruppen darstellt und eine ganze Zahl von 1 bis 3 ist, m jeweils unabhängig voneinander die Anzahl der gebundenen R¹ darstellt und eine Zahl ist, die durch Subtraktion von l von der Anzahl der austauschbaren Gruppen an Ar erhalten wird, und R² jeweils unabhängig voneinander ein Wasserstoffatom oder eine Alkylgruppe mit 1 bis 4 Kohlenstoffatomen darstellt; und
ein Epoxidharz (B).

2. Harzzusammensetzung gemäß Anspruch 1, wobei die Cyanatverbindung (A) eine Cyanatverbindung ist, die durch Cyanierung eines modifizierten Adamantanharzes erhalten wird.

3. Harzzusammensetzung gemäß Anspruch 1 oder 2, wobei die Cyanatverbindung (A) eine Cyanatverbindung umfasst, die eine Struktur der folgenden Formel (2) aufweist: 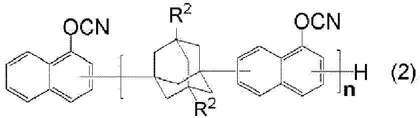 worin n 1,1 bis 20 als Mittelwert darstellt und R² jeweils unabhängig voneinander ein Wasserstoffatom oder eine Alkylgruppe mit 1 bis 4 Kohlenstoffatomen darstellt.

4. Harzzusammensetzung gemäß mindestens einem der Ansprüche 1 bis 3, wobei ein Gehalt der Cyanatverbindung (A) 1 bis 90 Masseteile, bezogen auf 100 Masseteile der Harzfeststoffe in der Harzzusammensetzung, beträgt.

5. Harzzusammensetzung gemäß mindestens einem der Ansprüche 1 bis 4, ferner umfassend einen Füllstoff (C).

6. Harzzusammensetzung gemäß mindestens einem der Ansprüche 1 bis 5, ferner umfassend eine oder mehrere, ausgewählt aus einer Gruppe bestehend aus einer Cyanatverbindung außer der Cyanatverbindung (A), einer Maleimidverbindung und einem Phenolharz.

7. Harzzusammensetzung gemäß mindestens einem der Ansprüche 1 bis 6, wobei das Epoxidharz (B) eines oder mehrere, ausgewählt aus einer Gruppe bestehend aus einem Epoxidharz auf Biphenylaralkylbasis, einem Epoxidharz auf Naphthylenetherbasis, einem polyfunktionellen Epoxidharz auf Phenolbasis und einem Epoxidharz auf Naphthalinbasis, umfasst.

8. Harzzusammensetzung gemäß mindestens einem der Ansprüche 5 bis 7, wobei ein Gehalt des Füllstoffs (C) 50 bis 1600 Masseteile, bezogen auf 100 Masseteile der Harzfeststoffe in einer Harzzusammensetzung, beträgt.

9. Prepreg, umfassend:
ein Basismaterial; und
die Harzzusammensetzung gemäß mindestens einem der Ansprüche 1 bis 8, mit welcher das Basismaterial imprägniert oder beschichtet ist.

10. Metallfolienplattiertes Laminat, umfassend:
mindestens eines oder mehrere der Prepregs gemäß Anspruch 9 gestapelt; und
Metallfolie, die auf einer Oberfläche oder beiden Oberflächen des Prepregs angeordnet ist.

11. Harzfolie, umfassend:
einen Träger; und
die Harzzusammensetzung gemäß mindestens einem der Ansprüche 1 bis 8, mit welcher eine Oberfläche des Trägers beschichtet ist und die getrocknet ist.

12. Eine gedruckte Leiterplatte, umfassend:
eine Isolierschicht; und
eine Leiterschicht, die auf einer Oberfläche der Isolierschicht gebildet ist, wobei
die Isolierschicht die Harzzusammensetzung gemäß mindestens einem der Ansprüche 1 bis 8 umfasst.

## Revendications

1. Composition de résine comprenant :
un composé cyanate (A) présentant une structure représentée par la formule (1) suivante : 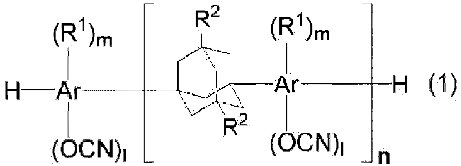 dans laquelle chaque Ar représente indépendamment un cycle aromatique, chaque R¹ représente indépendamment un atome d'hydrogène, un groupe alkyle, ou un groupe aryle, n représente de 1,1 à 20 à titre de valeur moyenne, chaque l représente indépendamment un nombre de groupes cyanato liés et est un nombre entier de 1 à 3, chaque m représente indépendamment un nombre de R¹ liés et représente un nombre obtenu par soustraction de l à un nombre de groupes remplaçables sur Ar, et chaque R² représente indépendamment un atome d'hydrogène ou un groupe alkyle présentant de 1 à 4 atomes de carbone ; et
une résine époxy (B).

2. Composition de résine selon la revendication 1, dans laquelle le composé cyanate (A) est un composé cyanate obtenu par cyanation d'une résine adamantane modifiée.

3. Composition de résine selon la revendication 1 ou 2, dans laquelle le composé cyanate (A) comprend un composé cyanate présentant une structure représentée par la formule (2) suivante : 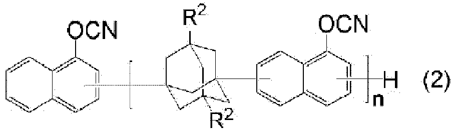 dans laquelle n représente 1,1 à 20 à titre de valeur moyenne, et chaque R² représente indépendamment un atome d'hydrogène ou un groupe alkyle présentant de 1 à 4 atomes de carbone.

4. Composition de résine selon l'une quelconque des revendications 1 à 3, dans laquelle une teneur en composé cyanate (A) est de 1 à 90 parties en masse sur la base de 100 parties en masse de matières solides de résine dans la composition de résine.

5. Composition de résine selon l'une quelconque des revendications 1 à 4, comprenant en outre une charge (C).

6. Composition de résine selon l'une quelconque des revendications 1 à 5, comprenant en outre l'un quelconque ou plus sélectionné dans un groupe consistant en un composé cyanate autre que le composé cyanate (A), un composé maléimide, et une résine phénolique.

7. Composition de résine selon l'une quelconque des revendications 1 à 6, dans laquelle la résine époxy (B) comprend l'une quelconque ou plus sélectionnée dans un groupe consistant en une résine époxy à base de biphényl aralkyle, une résine époxy à base d'éther de naphtylène, une résine époxy à base de phénol polyfonctionnel, et une résine époxy à base de naphtalène.

8. Composition de résine selon l'une quelconque des revendications 5 à 7, dans laquelle une teneur en la charge (C) est de 50 à 1600 parties en masse sur la base de 100 parties en masse de matières solides de résine dans une composition de résine.

9. Pré-imprégné comprenant :
un matériau de base ; et
la composition de résine selon l'une quelconque des revendications 1 à 8 avec laquelle le matériau de base est imprégné ou revêtu.

10. Stratifié revêtu d'une feuille métallique comprenant :
au moins un ou plusieurs des pré-imprégnés selon la revendication 9 empilés ; et
une feuille métallique disposée sur une surface ou sur les deux surfaces du pré-imprégné.

11. Feuille de résine comprenant :
un support ; et
la composition de résine selon l'une quelconque des revendications 1 à 8 avec laquelle une surface du support est revêtue et qui est séchée.

12. Carte de circuit imprimé comprenant :
une couche isolante ; et
une couche conductrice formée sur une surface de la couche isolante, dans laquelle
la couche isolante comprend la composition de résine selon l'une quelconque des revendications 1 à 8.
